# EUROPEAN PATENT APPLICATION

(11) **EP 0 973 194 A1**
(43) Date of publication of application: **19.01.2000**
(21) Application number: 99112729.1
(22) Date of filing: 01.07.1999
(51) Int. Cl.: H01L 21/768, H01L 23/522

(54) **Semiconductor device and manufacturing method thereof**

(30) Priority: 13.07.1998 JP 19775398
(71) Applicant: NEC CORPORATION, Tokyo (JP)
(72) Inventor: Shintaku, Hideomi, Minato-ku, Tokyo (JP)
(74) Representative: VOSSIUS & PARTNER

(57) **Abstract**

In the present invention, there is presented a method of manufacturing a semiconductor device wherein a contact hole (19) having a sidewall (20) of a CVD film (14) is formed in an interlayer film (5,11) overlying a semiconductor substrate (1) and, with this contact hole (19) being filled with a conductive material, thereby a contact (16) with the surface of the semiconductor substrate is formed; which comprises the steps of: setting an opening section (19) in this interlayer film (5,11) without exposing the surface of the semiconductor substrate; forming a CVD film (14) over a region including the inside surface of this opening section (19); removing the CVD film (14) at the bottom of the opening section (19) by etch back, and therewith removing the interlayer film (5) under the opening section so as to expose the surface of the semiconductor substrate (1); and filling this opening section (19) with a conductive material. The present invention provides a semiconductor device wherein the leakage current in a contact section is well suppressed and more particularly a semiconductor device which has an excellent hold characteristic in a memory circuit.

## Description

The present invention relates to a semiconductor device and a manufacturing method thereof and more particularly to a semiconductor device having a minute contact and a manufacturing method thereof.

In recent years, with the miniaturization of a semiconductor device, a diffusion layer region on a semiconductor substrate has been miniaturized. This, in turn, has been leading to a further miniaturization of a contact that makes electrical connection between such a minute diffusion layer and an electrode.

In the prior art, a contact hole is made through an interlayer film that is formed on a semiconductor substrate so as to reach a diffusion layer, and then a contact is formed, with this contact hole being filled with a conductive material. As the contact hole is miniaturized, however, the accurate patterning becomes very difficult, and especially so when the inside diameter thereof is 1 µm or less. Because of that, in methods generally employed, a contact hole is first formed to be larger than desired, and thereafter a sidewall is formed around the inside wall thereof with an insulating material such as silicon oxide by the CVD (Chemical Vapour Deposition) method, and thereby the contact hole is miniaturized.

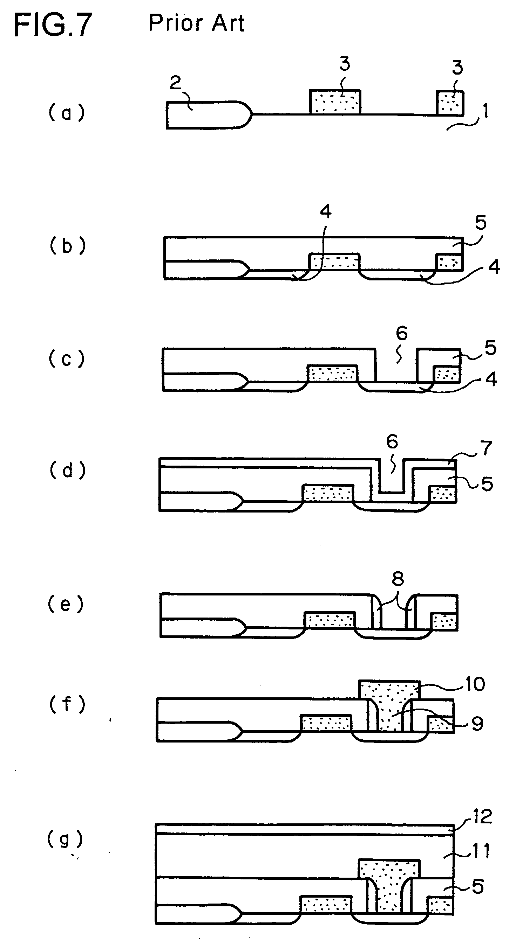

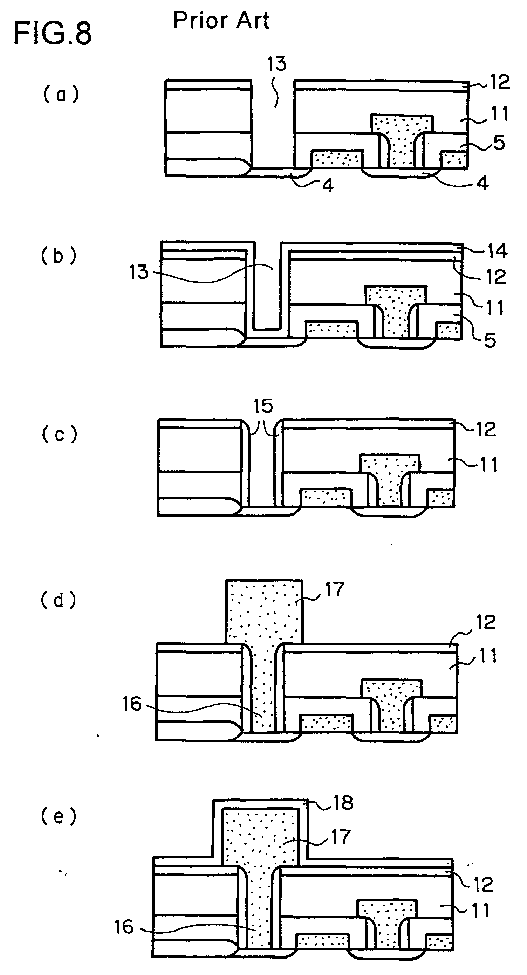

Now, with reference to Fig. 7 and Fig. 8, a conventional method is further described below, taking the formation of a stacked capacitor in a memory cell section of a DRAM (Dynamic Random Access Memory) as an example.

First, as shown in Fig. 7(a), over a semiconductor substrate 1 on which an element isolation region 2 made of a silicon oxide film is formed in a prescribed region, a gate oxide film ( not shown in the drawing ) is formed by the thermal oxidation method or the like. Then, after a doped polycrystalline silicon film is applied over the entire surface, a gate electrode 3 is formed by patterning.

Next, as shown in Fig. 7(b), a diffusion layer 4 is formed by means of ion implantation, and thereafter a first interlayer film 5 made of a BPSG (Boro-Phospho-Silicate Glass) film or the like is formed over the entire surface.

As shown in Fig. 7(c), a bit contact hole 6 is then formed to reach the diffusion layer 4 and subsequently, as shown in Fig. 7(d), an insulating film 7 is formed by the CVD method over the surface of the first interlayer film 5 including the inside surface of the bit contact hole 6. This CVD film 7 is subjected to the etch back, and thereby a sidewall 8 is formed, as shown in Fig. 7(e).

A conductive material is then applied and patterned in such a way that this bit contact hole 6 where the sidewall 8 is formed is filled up therewith, from which a bit contact 9 and a bit line 10 are formed, as shown in Fig. 7(f). After that, a second interlayer film made of a BPSG film or the like is formed over the entire surface, and an oxide film 12 is formed thereon ( Fig. 7(g)).

Next, as shown in Fig. 8(a), a capacitor contact hole 13 is formed to reach the diffusion layer 4 and subsequently, as shown in Fig. 8(b), an insulating film 14 is formed by the CVD method over the inside surface of the capacitor contact hole 13 as well as the surface of the oxide film 12. This CVD film 14 is subjected to the etch back, and thereby a sidewall 15 is formed, as shown in Fig. 8(c).

A conductive material is then applied and patterned in such a way that this capacitor contact hole 13 where the sidewall 15 is formed is filled up therewith, from which a capacitor contact 16 as well as a storage electrode 17 are formed, as shown in Fig. 8(d).

After that, a capacitor insulating film ( not shown in the drawing ) is formed, and then a doped polycrystalline silicon film 18 that is to serve as a plate electrode is formed thereon, accomplishing a capacitor structure. Finally, after a third interlayer film is formed thereon, other constituents such as an upper layer wiring are formed.

The conventional structure described above, however, has a problem that the leakage current may generate due to the creation of generation-recombination centers (GR centers), since the sidewall made of a CVD film directly touches the substrate surface. The generation of the leakage current at the capacitor contact in the memory circuit is especially a matter of grave concern under the current situations where it has become difficult to secure a sufficient capacitance as the miniaturization of the semiconductor device proceeds.

An object of the present invention is to provide a semiconductor device wherein the leakage current in a contact section is well suppressed and more particularly a semiconductor device which has an excellent hold characteristic in a memory circuit and a manufacturing method thereof.

The present invention relates to a method of manufacturing a semiconductor device wherein a contact hole having a sidewall made of a CVD film is formed in an interlayer film overlying a semiconductor substrate and, with said contact hole being filled with a conductive material, thereby a contact with the surface of said semiconductor substrate is formed; which comprises the steps of:
setting an opening section in said interlayer film by anisotropic etching without exposing the surface of said semiconductor substrate;
forming a CVD film over a region including the inside surface of said opening section;
removing the CVD film at the bottom of said opening section by etch back, and therewith removing the interlayer film under the opening section so as to expose the surface of the semiconductor substrate; and
filling said opening section with a conductive material.

Further, the present invention relates to a method of manufacturing a semiconductor device wherein a contact hole having a sidewall made of a CVD film is formed in an interlayer film overlying a semiconductor substrate and, with said contact hole being filled with a conductive material, thereby a contact with the surface of said semiconductor substrate is formed; which comprises the steps of:
forming a gate oxide film as well as a gate electrode, and thereafter forming a substrate protection film over said semiconductor substrate, and then forming said interlayer film thereon;
setting an opening section in said interlayer film by anisotropic etching so as to expose the surface of said substrate protection film;
forming a CVD film over a region including the inside surface of said opening section;
removing the CVD film at the bottom of said opening section by etch back, and therewith removing the substrate protection film under the opening section so as to expose the surface of the semiconductor substrate; and
filling said opening section with a conductive material.

Further, the present invention relates to a method of manufacturing a semiconductor device wherein a contact hole having a sidewall made of a CVD film is formed in an interlayer film overlying a semiconductor substrate and, with said contact hole being filled with a conductive material, thereby a contact with the surface of said semiconductor substrate is formed; which comprises the steps of:
setting an opening section in said interlayer film by anisotropic etching so as to expose the surface of said semiconductor substrate;
forming an insulating film over the exposed surface of said semiconductor substrate;
forming a CVD film over a region including the inside surface of said opening section;
removing the CVD film at the bottom of said opening section by etch back, and therewith removing the insulating film under the opening section so as to expose the surface of the semiconductor substrate; and
filling said opening section with a conductive material.

Further, the present invention relates to a semiconductor device wherein a contact hole having a sidewall made of a CVD film is formed in an interlayer film overlying a semiconductor substrate and, with said contact hole being filled with a conductive material, thereby a contact with the surface of said semiconductor substrate is formed; which has a structure in which the bottom section of said sidewall does not touch the surface of said semiconductor substrate.

Further, the present invention relates to a semiconductor device wherein a contact hole having a sidewall made of a CVD film is formed in an interlayer film overlying a semiconductor substrate and, with said contact hole being filled with a conductive material, thereby a contact with the surface of said semiconductor substrate is formed; which has a structure in which the bottom section of said sidewall comes in touch with a substrate protection film overlying said semiconductor substrate but not with the surface of said semiconductor substrate.

In all of the above-mentioned manufacturing methods of the present invention, formation of said opening section can be carried out after a film of said conductive material is formed over said interlayer film.

The present invention suppresses the leakage current and, especially in the memory circuit, provides excellent hold characteristics, resulting from a structural arrangement in the contact section thereof, that the sidewall made of a CVD film does not touch directly the surface of the substrate.
Fig. 1 is a series of fragmentary sectional views illustrating the steps of a manufacturing method in accordance with the first embodiment of the present invention.
Fig. 2 is a series of fragmentary sectional views illustrating the steps of a manufacturing method in accordance with the second embodiment of the present invention.
Fig. 3 is a series of fragmentary sectional views illustrating the steps of a manufacturing method in accordance with the third embodiment of the present invention.
Fig. 4 is a series of fragmentary sectional views illustrating further steps of the manufacturing method in accordance with the third embodiment of the present invention.
Fig. 5 is a series of fragmentary sectional views illustrating the steps of a manufacturing method in accordance with the fourth embodiment of the present invention.
Fig. 6 is a diagram showing a hold characteristic of a semiconductor device according to the present invention.
Fig. 7 is a series of fragmentary sectional views illustrating the steps of a manufacturing method of a conventional semiconductor device.
Fig. 8 is a series of fragmentary sectional views illustrating further steps of the manufacturing method of the conventional semiconductor device.

Using the formation of a stacked capacitor in a memory cell section of a DRAM as an example, the preferred embodiments of the present invention are described herein below.

### First embodiment

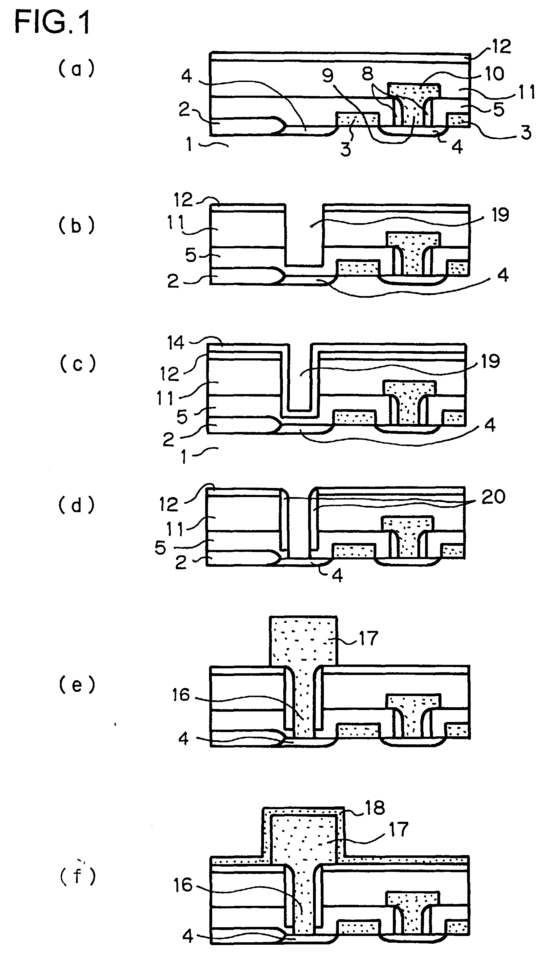

First, as shown in Fig. 1(a), there is carried out fabrication of a structure in which a MOS (Metal-Oxide-Semiconductor) transistor is formed on a semiconductor substrate 1 and an interlayer film is formed thereon. This structure is manufactured in the same way as the above-mentioned structure shown in Fig. 7(g). As for the reference numerals in Fig. 1(a), number 2 represents an element isolation region; number 3, a gate electrode; number 4, a diffusion layer; number 5, a first interlayer film; number 8, a sidewall made of a CVD film; number 9, a bit contact; number 10, a bit line; number 11, a second interlayer film; and number 12, an oxide film.

Further, the first and the second interlayer films are each made of a BPSG film or the like, and are formed, by the CVD method, to a thickness of 250 - 4000 nm or so and 200 - 4000 nm or so, respectively. Further, the insulating film 12 is set to serve as a stopper for the wet etching which removes a film of natural oxidation overlying the storage electrode in forming a capacitor insulating film. This insulating film 12 is formed to a thickness of 400 - 500 nm or so by the CVD method or the like, using an NSG (Non-Doped Silicate Glass) film or the like. In the present example, the first interlayer film and the second interlayer film each consist of a BPSG film and have the thickness of 300 nm. Further, the insulating film 12 consists of an NSG film and has a thickness of approximately 450 nm.

Next, as shown in Fig. 1(b), an opening section 19 is formed above the diffusion layer 4 by removing the insulating film 12 as well as the first and the second interlayer films by anisotropic etching. In the present example, the inside diameter of the opening section is 0.35 µm.

When such an opening 19 is formed, the etching must be stopped before the surface of the semiconductor substrate is exposed. With regard to the depth of this opening section 19, or the thickness of the insulating film left between the bottom face of the opening section 19 and the surface of the semiconductor substrate (referred to as "the residual film thickness", hereinafter), there is no specific limitation, as far as a sidewall to be formed in a later stage does not touch the surface of the substrate and, in effect, the leakage current is suppressed. None the less, in view of the control accuracy for the thickness of the interlayer film, this residual film thickness is preferably 200 nm or more. Further, the maximum of this residual film thickness is not subject to a specific limitation either, provided that etching can be well performed in making the substrate surface exposed after the formation of the sidewall, which is described below. Still, this residual film thickness is preferable to be 500 nm or less and more preferable to be 300 nm or less. In etching, the depth of the opening section 19 may be controlled, for example, through the etching time determined from the etching rate in dry etching and the thickness of the interlayer film. Examples of the conditions thereof in practice are as follows; CF₄ : 10 - 100 sccm (standard cubic centimeters minute), for example, 30 sccm; CHF₃ : 10 - 100 sccm, for example, 30 sccm; the gas pressure : 10 - 100 mTorr; and the power : 1 - 2 kW.

Next, as shown in Fig. 1(c), over the inside surface of the opening section 19 as well as the surface of the oxide film 12, an insulating film 14 of silicon oxide or the like is formed to a thickness of 50 - 150 nm or so by the CVD method. As for this CVD insulating film 14, a TEOS (Tetra-Ethyl-Ortho-Silicate) NSG film or a HTO (High-Temperature Oxide) film may be utilized as well. Subsequently, as shown in Fig. 1(d), this CVD film 14 is etched back by anisotropic etching to form a sidewall 20, and therewith both the first interlayer film and the gate oxide film under the opening section 19 are removed by etching so as to expose the surface of the semiconductor substrate. In the present example, the final inside diameter of the capacitor contact hole is set to be 0.2 µm. Examples of the etching conditions in practice are as follows; CF₄ : 10 - 100 sccm, for example, 30 sccm; CHF₃ : 10 - 100 sccm, for example, 30 sccm; the gas pressure : 100 - 1000 mTorr; and the power : 0.5 - 2 kW.

Next, a conductive material such as doped polycrystalline silicon or the like is applied and patterned in such a way that this capacitor contact hole where the sidewall 20 is formed is filled up therewith, from which a capacitor contact 16 as well as a storage electrode 17 are formed, as shown in Fig. 1(e).

After that, a capacitor insulating film ( not shown in the drawing ) is formed, and then a doped polycrystalline silicon film 18 which is to serve as a plate electrode is formed thereon, accomplishing a capacitor structure, as shown in Fig. 1(f). Finally, after a third interlayer film is formed thereon, other constituents such as an upper layer wiring are formed.

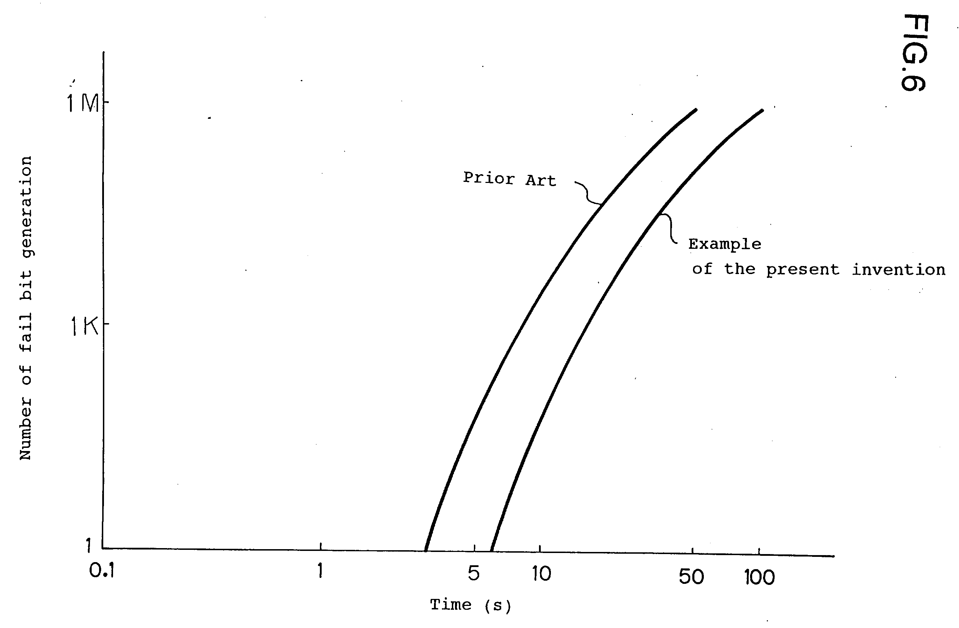

Fig. 6 shows a hold characteristic of a memory circuit having a capacitor structure as manufactured above. The number of the fail bit generation is the number of the fail bit that is generated in 1 M bit within a given time.

### Second embodiment

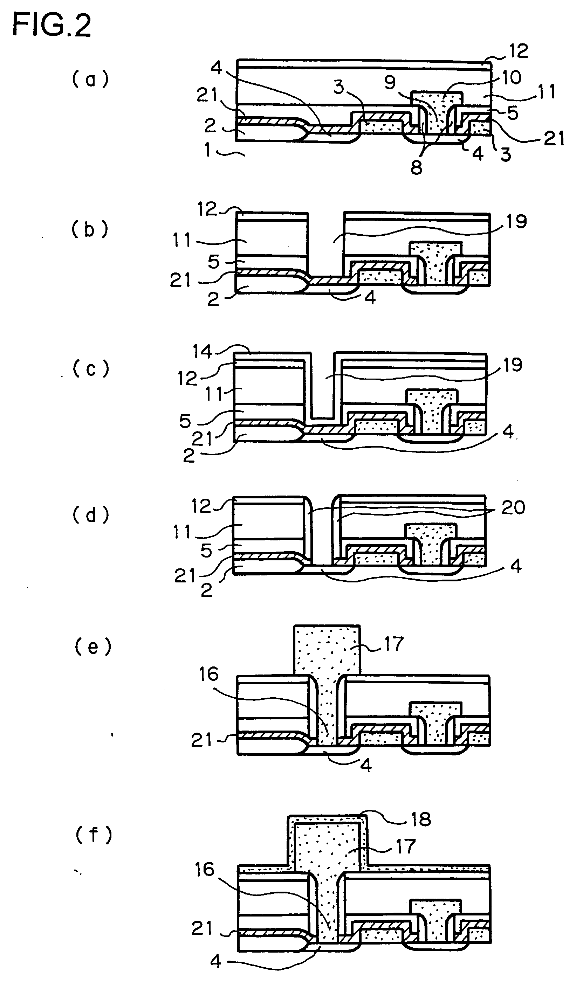

First, as shown in Fig. 2(a), there is carried out fabrication of a structure in which, over a semiconductor substrate 1 on which a MOS transistor is formed, a substrate protection film 21 of an NSG film or the like is formed to a thickness of 50 - 150 nm, for example, 100 nm, and then an interlayer film is formed thereon. This structure is manufactured in the same way as the above-mentioned structure shown in Fig. 7(g), except that the substrate protection film 21 is formed after the formation of the diffusion layer 4 and subsequently the first interlayer film 5 is formed. Further, other compositions are the same as the first embodiment.

Next, as shown in Fig. 2(b), an opening section 19 is formed above the diffusion layer 4. This opening section 19 is formed to reach the substrate protection film 21 by removing the insulating film 12 as well as the first and the second interlayer films by anisotropic etching. The depth of this etching may be controlled through the gas detection performed during the etching. For instance, in the case that a BPSG film is used as the first interlayer film 5 and an NSG film, as the substrate protection film 21, the etching should be stopped when the concentrations of boron (B) and phosphorus (P) in the gas generated in etching rapidly drop.

Next, as shown in Fig. 2(c), over the inside surface of the opening section 19 as well as the surface of the oxide film 12, an insulating film 14 of silicon oxide or the like is formed to a thickness of 50 - 150 nm or so by the CVD method. Subsequently, as shown in Fig. 2(d), this CVD film 14 is etched back by anisotropic etching to form a sidewall 20, and therewith both the substrate protection film 21 and the gate oxide film under the opening section 19 are removed by etching so as to expose the surface of the semiconductor substrate.

Next, a conductive material such as doped polycrystalline silicon or the like is applied and patterned in such a way that this capacitor contact hole where the sidewall 20 is formed is filled up therewith, from which a capacitor contact 16 as well as a storage electrode 17 are formed, as shown in Fig. 2(e).

After that, a capacitor insulating film ( not shown in the drawing ) is formed, and then a doped polycrystalline silicon film 18 which is to serve as a plate electrode is formed thereon, accomplishing a capacitor structure, as shown in Fig. 2(f). Finally, after a third interlayer film is formed thereon, other constituents such as an upper layer wiring are formed.

### Third embodiment

First, there is carried out fabrication of a structure that is the same as the structure of the above-mentioned second embodiment shown in Fig. 2(a) but with an etching stopper film of SiN or the like being formed in place of the substrate protection film 2. With respect to the etching stopper film used in the present invention, it is sufficient if it is composed of an electrically insulating material and has a substantially small etching rate, in comparison with a BPSG film used as an interlayer film. Accordingly, apart from SiN, an NSG film or the like, for instance, can also be utilized, although the etching rate thereof is rather large. Further, a structure in which an etching stopper film is lying over the substrate protection film 21 can be used.

Referring to Fig. 2 that is also referred to describe the second embodiment, the present embodiment is described below. Only the reference numeral 21 in Fig.2 is treated as the etching stopper film 121 in the present embodiment.

After the fabrication of the structure shown in Fig. 2(a) is carried out as described above, an opening section 19 is formed above the diffusion layer 4 to reach the etching stopper film 121 by removing the insulating film 12 as well as the first and the second interlayer films by anisotropic etching, as shown in Fig. 2(b). Since the depth of this etching is determined by the position of the etching stopper film 121, the opening section 19 having a prescribed depth is formed readily without the slightest possibility of over-etching.

Next, as shown in Fig. 2(c), over the inside surface of the opening section 19 as well as the surface of the oxide film 12, an insulating film 14 of silicon oxide or the like is formed to a thickness of 50 - 150 nm or so by the CVD method. Subsequently, as shown in Fig. 2(d), this CVD film 14 is etched back by anisotropic etching to form a sidewall 20, and therewith both the etching stopper film 121 and the gate oxide film under the opening section 19 are removed by etching so as to expose the surface of the semiconductor substrate. After this, a capacitor structure is manufactured in the same way as the second embodiment.

### Fourth embodiment

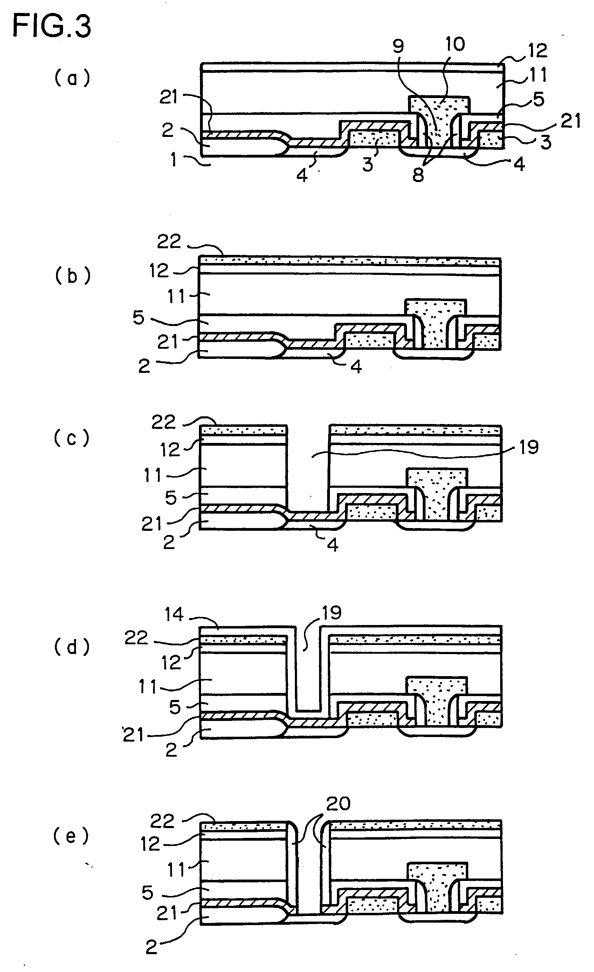

First, as shown in Fig. 3(a), there is carried out fabrication of a structure in which, over a semiconductor substrate 1 on which a MOS transistor is formed, a substrate protection film 21 of an NSG film or the like is formed and then an interlayer film is formed thereon. This structure is manufactured in the same way as the structure of the above-mentioned second embodiment shown in Fig. 2(a).

In the present embodiment, there may be set an etching stopper film 121 as the substrate protection film 21 like the third embodiment, or even no substrate protection film at all like the first embodiment. With respect to the insulating film 12, it is preferable to be formed thin, in comparison with those of the first - third embodiments, for instance, with a thickness of 20 - 30 nm.

Next, as shown in Fig. 3(b), over the entire surface of the insulating film 12, a doped polycrystalline silicon film 22 is formed to a thickness of 50 - 500 nm. This polycrystalline silicon film 22 serves as an etching stopper film at the time of etch back in the formation of a sidewall which is described below, and, in addition, is to constitute a part of an storage electrode.

Next, as shown in Fig. 3(c), an opening section 19 is formed above the diffusion layer 4. This opening section 19 is formed to reach the substrate protection film 21 by removing the insulating film 12 as well as the first and the second interlayer films by anisotropic etching. The depth of this etching may be controlled through the gas detection performed during the etching. In the cases that no substrate protection film 21 is set and that the etching stopper film 121 is set in place of the substrate protection film 21, an opening section 19 is formed in the same way as the first and the third embodiments, respectively.

Next, as shown in Fig. 3(d), over the inside surface of the opening section 19 as well as the surface of the polycrystalline silicon film 22, an insulating film 14 of silicon oxide or the like is formed to a thickness of 50 - 150 nm or so by the CVD method. Subsequently, as shown in Fig. 3(e), this CVD film 14 is etched back by anisotropic etching to form a sidewall 20, and therewith both the substrate protection film 21 and the gate oxide film under the opening section 19 are removed by etching so as to expose the surface of the semiconductor substrate. Since the polycrystalline silicon film 22 serves as an etching stopper thereat, the surface of the insulating film 12 cannot be over-etched.

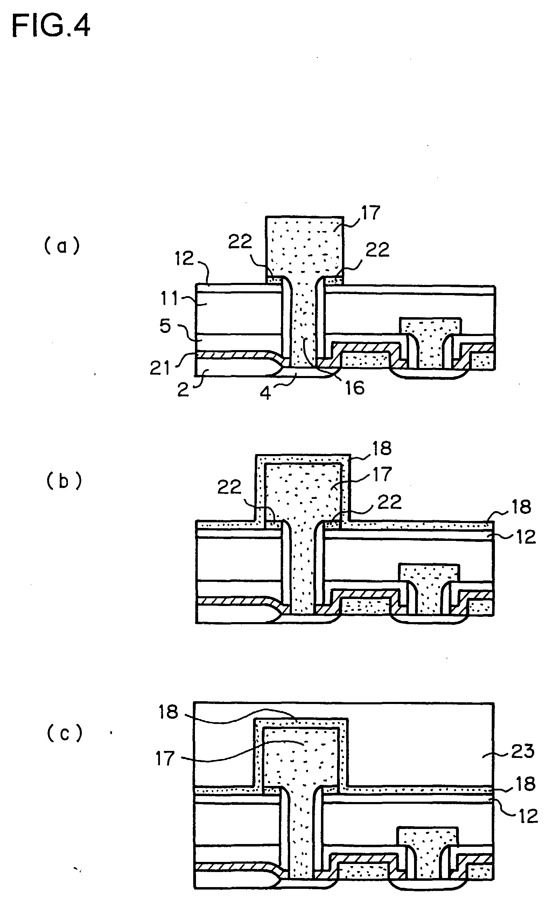

Next, a conductive material such as doped polycrystalline silicon or the like is applied and patterned in such a way that this capacitor contact hole where the sidewall 20 is formed is filled up therewith, from which a capacitor contact 16 as well as a storage electrode 17 are formed, as shown in Fig. 4(a). In this patterning, the polycrystalline silicon film 22 is simultaneously patterned to constitute a lower section of a storage electrode.

After that, a capacitor insulating film ( not shown in the drawing ) is formed, and then a doped polycrystalline silicon film 18 which is to serve as a plate electrode is formed thereon, accomplishing a capacitor structure, as shown in Fig. 4(b). Finally, after a third interlayer film 23 is formed thereon, as shown in Fig. 4(c), other constituents such as an upper layer wiring are formed.

### Fifth embodiment

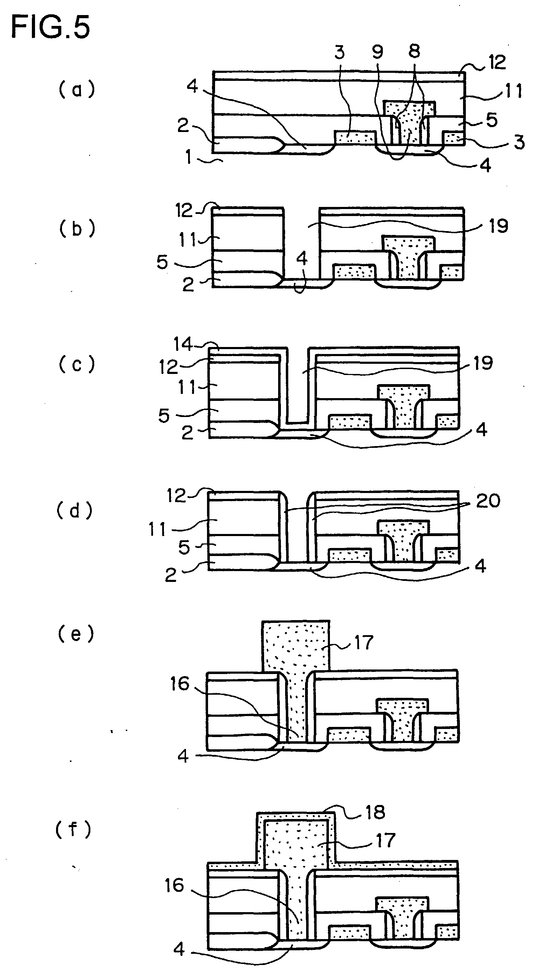

First, as shown in Fig. 5(a), there is carried out fabrication of a structure in which a MOS transistor is formed on a semiconductor substrate 1 and an interlayer film is formed thereon. This structure is manufactured in the same way as the structure of the first embodiment shown in Fig. 1(a).

Next, as shown in Fig. 5(b), an opening section 19 is formed above the diffusion layer 4 so as to expose the surface of the semiconductor substrate. This opening section 19 is formed by removing the insulating film 12 as well as the first and the second interlayer films by anisotropic etching.

Subsequently, over the exposed surface of the semiconductor substrate at the bottom of the opening section 19, a film of the thermal oxidation ( not shown in the drawing ) is formed to a thickness of 5 - 10 nm by the thermal oxidation method. This thermal oxidation film is formed, for example, under the conditions that the temperature is 800 °C, the gas is O₂ and N₂ and the time is 10 - 30 minutes.

Next, as shown in Fig. 5(c), over the inside surface of the opening section 19 as well as the surface of the oxide film 12, an insulating film 14 of silicon oxide or the like is formed to a thickness of 50 - 150 nm or so by the CVD method. Subsequently, as shown in Fig. 5(d), this CVD film 14 is etched back by anisotropic etching to form a sidewall 20, and therewith the thermal oxidation film on the substrate surface is removed by etching so as to expose the surface of the semiconductor substrate.

Next, a conductive material such as doped polycrystalline silicon or the like is applied and patterned in such a way that this capacitor contact hole where the sidewall 20 is formed is filled up therewith, from which a capacitor contact 16 as well as a storage electrode 17 are formed, as shown in Fig. 5(e).

After that, a capacitor insulating film ( not shown in the drawing ) is formed, and then a doped polycrystalline silicon film 18 which is to serve as a plate electrode is formed thereon, accomplishing a capacitor structure, as shown in Fig. 5(f). Finally, after a third interlayer film is formed thereon, other constituents such as an upper layer wiring are formed.

## Claims

1. A method of manufacturing a semiconductor device wherein a contact hole having a sidewall made of a CVD film is formed in an interlayer film overlying a semiconductor substrate and, with said contact hole being filled with a conductive material, thereby a contact with the surface of said semiconductor substrate is formed; which comprises the steps of:
setting an opening section in said interlayer film by anisotropic etching without exposing the surface of said semiconductor substrate;
forming a CVD film over a region including the inside surface of said opening section;
removing the CVD film at the bottom of said opening section by etch back, and therewith removing the interlayer film under the opening section so as to expose the surface of the semiconductor substrate; and
filling said opening section with a conductive material.

2. A method of manufacturing a semiconductor device wherein a contact hole having a sidewall made of a CVD film is formed in an interlayer film overlying a semiconductor substrate and, with said contact hole being filled with a conductive material, thereby a contact with the surface of said semiconductor substrate is formed; which comprises the steps of:
forming a gate oxide film as well as a gate electrode, and thereafter forming a substrate protection film over said semiconductor substrate, and then forming said interlayer film thereon;
setting an opening section in said interlayer film by anisotropic etching so as to expose the surface of said substrate protection film;
forming a CVD film over a region including the inside surface of said opening section;
removing the CVD film at the bottom of said opening section by etch back, and therewith removing the substrate protection film under the opening section so as to expose the surface of the semiconductor substrate; and
filling said opening section with a conductive material.

3. A method of manufacturing a semiconductor device according to Claim 2, wherein said substrate protection film is an NSG film and said interlayer film is a BPSG film.

4. A method of manufacturing a semiconductor device according to Claim 2, wherein said substrate protection film is an etching stopper film.

5. A method of manufacturing a semiconductor device wherein a contact hole having a sidewall made of a CVD film is formed in an interlayer film overlying a semiconductor substrate and, with said contact hole being filled with a conductive material, thereby a contact with the surface of said semiconductor substrate is formed; which comprises the steps of:
setting an opening section in said interlayer film by anisotropic etching so as to expose the surface of said semiconductor substrate;
forming an insulating film over the exposed surface of said semiconductor substrate;
forming a CVD film over a region including the inside surface of said opening section;
removing the CVD film at the bottom of said opening section by etch back, and therewith removing the insulating film under the opening section so as to expose the surface of the semiconductor substrate; and
filling said opening section with a conductive material.

6. A method of manufacturing a semiconductor device according to Claim 5, wherein said insulating film formed at the bottom of said opening section is a thermal oxidation film.

7. A method according to any one of claims 1 to 6,
wherein a film of said conductive material is formed over said interlayer film and thereafter said opening section is formed.

8. A semiconductor device wherein a contact hole having a sidewall made of a CVD film is formed in an interlayer film overlying a semiconductor substrate and, with said contact hole being filled with a conductive material, thereby a contact with the surface of said semiconductor substrate is formed; which has a structure in which the bottom section of said sidewall does not touch the surface of said semiconductor substrate.

9. A semiconductor device wherein a contact hole having a sidewall made of a CVD film is formed in an interlayer film overlying a semiconductor substrate and, with said contact hole being filled with a conductive material, thereby a contact with the surface of said semiconductor substrate is formed; which has a structure in which the bottom section of said sidewall comes in touch with a substrate protection film overlying said semiconductor substrate but not with the surface of said semiconductor substrate.

10. A semiconductor device according to claim 8 or 9, wherein said substrate protection film is a thermal oxidation film.

11. A semiconductor device according to claim 8 or 9, wherein said substrate protection film is an NSG film and said interlayer film is a BPSG film.

12. A semiconductor device according to claim 8 or 9, wherein said substrate protection film is an etching stopper film.
